# EUROPÄISCHE PATENTANMELDUNG

(11) **EP 1 850 140 A2**
(43) Veröffentlichungstag der Anmeldung: **31.10.2007**
(21) Anmeldenummer: 07008080.9
(22) Anmeldetag: 20.04.2007
(51) Int. Cl.: G01R 31/28

(54) **Schaltungsanordnung mit mindestens einem Sensor und einer Auswerteeinheit**

(30) Priorität: 24.04.2006 DE 102006019319
(71) Anmelder: i f m electronic gmbh, 45127 Essen (DE)
(72) Erfinder: Lamarche, Jean-Luc, 672006 Mittelhausbergen (FR); Strobel, Manfred, 88250 Weingarten (DE)
(74) Vertreter: Gesthuysen, von Rohr & Eggert

(57) **Zusammenfassung**

Beschrieben und dargestellt ist eine Schaltungsanordnung mit einem Sensor (1) und einer Auswerteeinheit (2), wobei der Sensor (1) eine Sicherheitsendstufe (3) aufweist und die Funktionstüchtigkeit der Schaltungsanordnung insgesamt und insbesondere der Sicherheitsendstufe (3) im Sensor und/oder durch die Auswerteeinheit (2) abfragbar ist.

Die erfindungsgemäße Schaltungsanordnung funktioniert auch dann, wenn die an sie angeschlossene Schaltung kapazitiv ist, und zwar dadurch, daß eine die Spannung am Ausgang (6) der Sicherheitsendstufe (3), also die Ausgangsspannung der Sicherheitsendstufe (3) überwachende Überwachungseinheit (11) vorgesehen ist, daß die Überwachungseinheit (11) in Koinzidenz zum Abfragen der Sicherheitsendstufe (3) aktivierbar ist und daß die Überwachungseinheit (11) jeweils dann und nur dann einen die Funktionstüchtigkeit der Schaltungsanordnung darstellenden Antwortimpuls generiert, wenn die Ausgangsspannung der Sicherheitsendstufe (3) einen vorgegebenen Wert die Referenzspannung, unterschreitet oder wenn die Ausgangsspannung der Sicherheitsendstufe (3) die Versorgungsspannung des Sensors (1) um einen vorgegebenen Wert unterschreitet.

## Beschreibung

Die Erfindung betrifft eine Schaltungsanordnung mit mindestens einem Sensor und mit einer Auswerteeinheit, wobei der Sensor eine Sicherheitsendstufe aufweist und die Funktionstüchtigkeit der Sicherheitsendstufe im Sensor- und/oder durch die Auswerteeinheit abfragbar ist. Statt eines Sensors kann auch ein anderes elektrisches oder elektronisches Gerät vorgesehen sein, das eine Sicherheitsendstufe aufweist. Nachfolgend wird jedoch immer nur eine Schaltungsanordnung beschrieben, zu der ein Sensor mit einer Sicherheitsendstufe gehört, ohne daß damit eine Beschränkung auf eine Schaltungsanordnung mit einem Sensor verbunden sein soll oder verbunden ist.

Schaltungsanordnungen der zuvor nur in ihrem grundsätzlichen Aufbau und nur ihrer grundsätzlichen Funktion nach beschriebenen Art sind vielfach bekannt und werden immer dann benötigt, wenn der Sensor oder die Sensoren (nachfolgend wird immer nur ein Sensor behandelt) sicherheitsrelevante Zustände, Funktionen usw. überwachen oder sicherstellen soll. Folglich muß die Auswerteeinheit erkennen bzw. ansprechen, ob bzw. wenn
a) dem Sensor die Versorgungsspannung fehlt oder die Verbindung zwischen der Auswerteeinheit und dem Sensor fehlerbehaftet ist, z. B. weil ein Aderbruch in der Versorgungsspannungsleitung oder in der Verbindungsleitung zwischen dem Sensor und der Auswerteeinheit vorliegt,
b) ein Kurzschluß oder ein Erdschluß vorliegt oder
c) der Sensor - mit seiner Sicherheitsendstufe - nicht funktionstüchtig ist.

Eingangs ist ausgeführt, daß bei der Schaltungsanordnung, von der die Erfindung ausgeht, die Funktionstüchtigkeit der Sicherheitsendstufe des Sensors im Sensor und/oder durch die Auswerteeinheit abfragbar ist.

Bei der Ausführungsform, bei der die Funktionstüchtigkeit der Sicherheitsendstufe im Sensor abfragbar ist, werden im Sensor Abfrageimpulse generiert.

Diese Abfrageimpulse generieren Antwortimpulse, wenn der Sensor - mit seiner Sicherheitsendstufe - funktionstüchtig ist.

Bei der Ausführungsform, bei der die Funktionstüchtigkeit der Sicherheitsendstufe des Sensors durch die Auswerteeinheit abfragbar ist, werden von der Auswerteeinheit an den Sensor - über die Verbindungsleitung zwischen dem Sensor und der Auswerteeinheit - Abfrageimpulse gegeben, die den Sensor bzw. dessen Sicherheitsendstufe aktivieren und Antwortimpulse generieren, wenn der Sensor - mit seiner Sicherheitsendstufe - funktionstüchtig ist.

Bei beiden Ausführungsformen bekommt die Auswerteeinheit dann keine Antwortimpulse, wenn
a) dem Sensor die Versorgungsspannung fehlt oder die Verbindung zwischen dem Sensor und der Auswerteeinheit fehlerbehaftet ist, z. B. weil ein Aderbruch in der Versorgungsspannungsleitung oder in der Verbindungsleitung zwischen der Auswerteeinheit und dem Sensor vorliegt,
b) ein Kurzschluß oder ein Erdschluß vorliegt oder
c) der Sensor - mit seiner Sicherheitsendstufe - nicht funktionstüchtig ist, wenn also einer der weiter oben aufgezeigten Fehler vorliegt.

Bei einer Schaltungsanordnung der in Rede stehenden Art schaltet die Sicherheitsendstufe normalerweise nur dann, wenn der Sensor beeinflußt wird, - bei einem als Öffner ausgeführten Sensor wird ein zu der Sicherheitsendstufe gehörender, normalerweise leitender elektronischer Schalter nicht-leitend, bei einem als Schließer ausgeführten Sensor wird ein zu der Sicherheitsendstufe gehörender, normalerweise nicht-leitender elektronischer Schalter leitend. Daraus folgt, daß die Abfrageimpulse und die daraus - im fehlerfreien Zustand - abgeleiteten Antwortimpulse so kurz sein müssen, daß die in der Auswerteeinheit angekommenen Antwortimpulse als solche erkannt werden können, also von dem normalen Schalten bzw. den normalen Schaltimpulsen des Sensors auch bei relativ hohen Schaltfrequenzen und folglich relativ kurzen Schaltzeiten unterschieden werden können.

Im folgenden wird davon ausgegangen, daß die in Rede stehende Schaltungsanordnung mit Öffner-Funktion eingesetzt wird. Im fehlerfreien Zustand ist also der entsprechende Sicherheitsstromkreis geschlossen; tritt ein Fehler auf, öffnet der elektronische Schalter in der Sicherheitsendstufe des Sensors, der Sicherheitsstromkreis wird stromlos. Daraus resultiert die Forderung, daß die Auswerteeinheit auch dann - relativ schnell - auf ein Öffnen des elektronischen Schalters reagiert, wenn die angeschlossene Schaltung kapazitiv ist. Bei einem zum positiven Potential schaltenden, also P-schaltenden Sensor liegt der Ausgang des Sensors bei leitendem elektronischen Schalter auf positivem Potential. Das gilt natürlich auch für die gesamte, an den Ausgang des Sensors angeschlossene Schaltung, also auch für zu dieser Schaltung gehörende Kapazitäten, - seien es konkret vorgesehene Kapazitäten, sei es die Kapazität der Verbindungsleitung zwischen dem Sensor und der Auswerteeinheit, seien es parasitäre Kapazitäten. Die Auswerteeinheit erkennt also erst dann eine den elektronischen Schalter des Sensors öffnende Beeinflussung, wenn die Kapazitäten der angeschlossenen Schaltung hinreichend weit entladen sind.

Um auch bei Schaltungsanordnungen, an die eine kapazitive Schaltung angeschlossen ist, relativ hohe Schaltfrequenzen und folglich relativ kurze Schaltzeiten erreichen zu können, hat man die Endstufen der Sensoren (oder anderer elektrischer oder elektronischer Geräte) als Push-pull-Endstufen ausgeführt. Jedenfalls hier ist mit einer Push-pull-Endstufe eine solche gemeint, die zusätzlich zu dem eigentlichen elektronischen Schalter einen weiteren elektronischen Schalter - in Reihe zu dem eigentlichen elektronischen Schalter - aufweist, der dann leitend wird, also schließt, wenn der eigentliche elektronische Schalter nicht-leitend wird, also sperrt bzw. öffnet. Über diesen weiteren elektronischen Schalter können dann in sehr kurzer Zeit vorhandene Kapazitäten, die im leitenden Zustand des eigentlichen elektronischen Schalters aufgeladen sind, entladen werden.

Bei einer Schaltungsanordnung mit einem Sensor, dessen Endstufe als Push-pull-Endstufe ausgeführt ist, stellt die Verbindung der beiden Schaltstrecken des eigentlichen elektronischen Schalters und des weiteren elektronischen Schalters den Ausgang des Sensors dar. Dieser Ausgang liegt bei einem P-schaltenden Sensor dann, wenn der eigentliche elektronische Schalter leitend ist, auf positiven Potential. Er liegt dann auf negativen Potential, wenn der eigentliche elektronische Schalter nicht-leitend ist, also sperrt. Ist die Endstufe als Push-pull-Endstufe ausgeführt, so kann der Ausgang aber auch dann auf negativem Potential liegen, jedenfalls "in der Nähe" des negativen Potentials, nicht jedoch auf positiven Potential, wenn der weitere elektronische Schalter leitend geworden ist.

Bei einer Push-pull-Endstufe arbeiten die beiden elektronischen Schalter antivalent; d. h. "gleichzeitig" öffnet der eigentliche elektronische Schalter und schließt der weitere elektronische Schalter. Bei einer Sicherheitsendstufe soll jedoch nicht die Ansteuerung des elektronischen Schalters überwacht werden, vielmehr soll die Funktionstüchtigkeit des elektronischen Schalters überwacht werden. Aus diesem Grund kann das Problem einer angeschlossenen kapazitiven Schaltung bei einer Schaltungsanordnung der in Rede stehenden Art nicht dadurch gelöst werden, daß die Endstufe als Pull-push-Endstufe ausgeführt ist, weil eine solche Push-pull-Endstufe, wie zuvor erläutert, keine Sicherheitsendstufe in dem hier geforderten Sinne ist, nämlich nicht wirklich die Funktionstüchtigkeit des eigentlichen elektronischen Schalters überprüft und überwacht werden kann.

Der Erfindung liegt das zuvor geschilderte Problem und damit die Aufgabe zugrunde, eine Schaltungsanordnung der in Rede stehenden Art anzugeben, die auch dann "funktioniert", wenn die angeschlossene Schaltung kapazitiv ist, - sei es durch konkret vorgesehene Kapazitäten, sei es durch die Kapazität der Verbindungsleitung zwischen dem Sensor und der Auswerteeinheit, sei es durch parasitäre Kapazitäten; dabei meint "funktioniert", daß durch relativ kurze Abfrageimpulse mit relativ hoher Abfragefrequenz die Funktionstüchtigkeit der gesamten Schaltungsanordnung und insbesondere die der Sicherheitsendstufe überprüft und überwacht werden kann.

Die erfindungsgemäße Schaltungsanordnung, bei der die zuvor hergeleitete und aufgezeigte Aufgabe gelöst ist, ist zunächst und im wesentlichen dadurch gekennzeichnet, daß eine die Spannung am Ausgang der Sicherheitsendstufe, also die Ausgangsspannung der Sicherheitsendstufe überwachende Überwachungseinheit vorgesehen ist, daß die Überwachungseinheit in Koinzidenz zum Abfragen der Sicherheitsendstufe aktivierbar ist und daß die Überwachungseinheit jeweils dann und nur dann einen die Funktionstüchtigkeit der Schaltungsanordnung darstellenden Antwortimpuls generiert, wenn die Ausgangsspannung der Sicherheitsendstufe einen vorgegebenen Wert unterschreitet oder wenn die Ausgangsspannung der Sicherheitsendstufe die Versorgungsspannung des Sensors um einen vorgegeben Wert unterschreitet. Erfindungsgemäß wird also die Ausgangsspannung der Sicherheitsendstufe überwacht und überprüft, und zwar immer genau dann, wenn ein Abfrageimpuls generiert wird, sei es im Sensor, sei es durch die Auswerteeinheit, und wird jeweils dann und nur dann ein die Funktionstüchtigkeit der Schaltungsanordnung darstellender Antwortimpuls generiert, wenn die Ausgangsspannung der Sicherheitsendstufe einen vorgegebenen Wert unterschreitet oder wenn die Ausgangsspannung der Sicherheitsendstufe die Versorgungsspannung des Sensors um einen vorgegebenen Wert unterschreitet.

Bisher ist immer gesagt worden, daß die Überwachungseinheit dann und nur dann einen die Funktionstüchtigkeit der Schaltungsanordnung darstellenden Antwortimpuls generiert, wenn die Ausgangsspannung der Sicherheitsendstufe einen vorgegebenen Wert, eine Referenzspannung unterschreitet oder wenn die Ausgangsspannung der Sicherheitsendstufe die Versorgungsspannung des Sensors um einen vorgegebenen Wert unterschreitet. Das kann vorzugsweise auch dadurch realisiert werden, daß der Spannungswert der Ausgangsspannung der Sicherheitsendstufe vor dem Auftreten jedes Abfrageimpulses erfaßt und gespeichert wird, daß der Spannungswert der Ausgangsspannung der Sicherheitsendstufe nach dem Auftreten jedes Abfrageimpulses erfaßt wird und mit dem gespeicherten Spannungswert der Ausgangsspannung der Sicherheitsendstufe vor dem Auftreten jedes Abfrageimpulses verglichen wird und daß dann, wenn die Differenz dieser beiden Spannungswerte einen vorgegebenen Wert überschreitet, Antwortimpulse generiert werden. Es wird also der während der Dauer des Abfrageimpulses fortlaufend sinkende Spannungswert der Ausgangsspannung der Sicherheitsendstufe mit dem gespeicherten Wert der Ausgangsspannung der Sicherheitsendstufe vor dem Auftreten des Abfrageimpulses verglichen. Überschreitet während der Dauer des Abfrageimpulses die Differenz dieser beiden Spannungswerte einen vorgegebenen Wert, so wird ein die Funktionstüchtigkeit der Sicherheitsendstufe darstellender Antwortimpuls generiert. Wird dieser Wert während der Dauer des Abfrageimpulses nicht überschritten, so wird ein Antwortimpuls nicht generiert. Zusätzlich zu dem Nicht-Generieren des Antwortimpulses kann die Fehlerhaftigkeit der Sicherheitsendstufe, die dann gegeben ist, auch durch das Generieren eines Fehlerimpulses erkennbar und auswertbar gemacht werden.

Im einzelnen gibt es verschiedenen Möglichkeiten, die zuvor bewußt sehr allgemein formulierte, aber gleichwohl für den Fachmann ohne weiteres nachvollziehbare Lehre der Erfindung auszugestalten und weiterzubilden.

Als zur Lehre der Erfindung gehörend ist zuvor ausgeführt worden, daß die Überwachungseinheit jeweils dann und nur dann einen die Funktionstüchtigkeit der Schaltungsanordnung darstellenden Antwortimpuls generiert, wenn die Ausgangsspannung der Sicherheitsendstufe einen vorgegebenen Wert, die Referenzspannung, unterschreitet oder wenn die Ausgangsspannung der Sicherheitsendstufe die Versorgungsspannung des Sensors um einen vorgegebenen Wert unterschreitet. Also muß die Ausgangsspannung der Sicherheitsendstufe erfaßt und verglichen werden, und zwar entweder mit der Referenzspannung oder mit der Versorgungsspannung des Sensors. Dann, wenn die Ausgangsspannung der Sicherheitsendstufe einen vorgegebenen Wert unterschreitet, also die Referenzspannung unterschreitet, oder wenn die Ausgangsspannung der Sicherheitsendstufe die Versorgungsspannung des Sensors um einen vorgegebenen Wert unterschreitet, wird ein die Funktionstüchtigkeit der Schaltungsanordnung darstellender Antwortimpuls generiert. Im einfachsten Fall weist folglich die Überwachungseinheit einen Komparator auf, der die Ausgangsspannung der Sicherheitsendstufe erfaßt und mit der Referenzspannung oder der Versorgungsspannung des Sensors vergleicht. Vorzugsweise - moderner Technologie entsprechend - weist die Überwachungseinheit einen die Ausgangsspannung der Sicherheitsendstufe erfassenden A/D-Wandler, einen den Referenzwert oder die Versorgungsspannung des Sensors erfassenden A/D-Wandler und einen die digitalisierte Ausgangsspannung der Sicherheitsendstufe und die digitalisierte Referenzspannung oder die digitalisierte Versorgungsspannung des Sensors vergleichenden Komparator auf. Dabei kann der Komparator als Differenzverstärker ausgeführt sein, vorzugsweise ist der Komparator jedoch als µController ausgeführt.

Weiter oben ist als das der Erfindung zugrundeliegende Problem eine an die Schaltungsanordnung angeschlossene kapazitive Schaltung beschrieben worden. Dabei ist auch ausgeführt worden, daß es sich bei der zu der kapazitiven Schaltung gehörenden Kapazität um konkret vorgesehene Kapazitäten, um die Kapazität der Verbindungsleitung zwischen dem Sensor und der Auswerteeinheit oder/und um parasitäre Kapazitäten handeln kann. Die Größe der Kapazität der an die erfindungsgemäße Schaltungsanordnung angeschlossenen Schaltung ist also kaum vorhersehbar und kann in weiten Grenzen variieren. Die Konsequenz ist, daß die Entladekurve der an die erfindungsgemäße Schaltungsanordnung angeschlossenen kapazitiven Schaltung sehr unterschiedlich sein kann. Folglich kann auch die Entladezeit, die benötigt wird, damit die Ausgangsspannung der Sicherheitsendstufe die Referenzspannung unterschreitet bzw. die Versorgungsspannung des Sensors um einen vorgegebenen Wert unterschreitet, sehr unterschiedlich sein. Deshalb geht eine weitere Lehre der Erfindung, die zunächst kontraproduktiv zu sein scheint, dahin, am Sensor oder/und an der Auswerteeinheit ausgangsseitig eine Linearisierungskapazität bzw. Linearisierungskapazitäten vorzusehen; ausgangsseitig meint beim Sensor selbstverständlich den der Auswerteeinheit zugeordneten Ausgang der Sicherheitsendstufe, meint bei der Auswerteeinheit den dem Sensor zugewandten Ausgang der Auswerteeinheit. Das Vorsehen einer besonderen Linearisierungskapazität - ausgangsseitig am Sensor oder ausgangsseitig an der Auswerteeinheit - oder das Vorsehen einer Linearisierungskapazität am Sensor und einer weiteren Linearisierungskapazität an der Auswerteeinheit führt dazu, jedenfalls dann, wenn die Linearisierungskapazität bzw. die Linearisierungskapazitäten hinreichend groß gewählt werden, daß in ihrer Größe nicht vorhersehbare, zu der an die erfindungsgemäße Schaltungsanordnung angeschlossenen Schaltung gehörende Kapazitäten die insgesamt wirksame Kapazität nur unwesentlich beeinflussen, so daß auch die Entladezeit, die benötigt wird, bis die Ausgangsspannung der Sicherheitsendstufe die Referenzspannung unterschreitet oder die Versorgungsspannung des Sensors um einen vorgegebenen Wert unterschreitet, von der an die erfindungsgemäße Schaltungsanordnung angeschlossenen Schaltung und den zu dieser Schaltung gehörenden Kapazitäten kaum noch abhängig ist.

Im Stand der Technik, von dem die Erfindung ausgeht, ist die Schaltfrequenz des Sensors jedenfalls auch dadurch begrenzt, daß die minimal mögliche Schaltzeit - damit ist hier der zeitliche Abstand zwischen einem Schalten und dein darauf folgenden Schalten gemeint - größer sein muß als die Entladezeit der Kapazitäten, die zu der an die Schaltungsanordnung angeschlossenen Schaltung gehören; im Stand der Technik muß die Zeit zwischen einem Schalten des Sensors und dem darauf folgenden Schalten so groß sein, daß dann, wenn die Schaltungsanordnung funktionstüchtig ist, Antwortimpulse der Sicherheitsendstufe generiert werden können. Demgegenüber ist es für die erfindungsgemäße Schaltungsanordnung ausreichend, daß zwischen einem Schalten des Sensors und dem darauf folgenden Schalten bei beeinflußtem Sensor, richtiger gesagt: bei geöffnetem elektronischen Schalter der Sicherheitsendstufe die Ausgangsspannung der Sicherheitsendstufe die Referenzspannung unterschreiten kann oder die Versorgungsspannung des Sensors um einen vorgegebenen Wert unterschreiten kann.

Es sei noch darauf hingewiesen, daß normalerweise dann, wenn der zur Sicherheitsendstufe des Sensors gehörende elektronische Schalter leitend ist, die Ausgangsspannung der Sicherheitsendstufe nur geringfügig unter der Versorgungsspannung des Sensors liegt, nämlich nur um den Spannungsabfall an der Schaltstrecke des zur Sicherheitsendstufe gehörenden elektronischen Schalters. Man kann deshalb für das Generieren von Antwortimpulsen sowohl die Ausgangsspannung der Sicherheitsendstufe mit einer Referenzspannung, z. B. abgeleitet von der Versorgungsspannung des Sensors, als auch mit der Versorgungsspannung des Sensors vergleichen.

Im folgenden wird nun die Erfindung in Verbindung mit einer ein Ausführungsbeispiel darstellenden Zeichnung nochmals erläutert; es zeigen
- Fig. 1: weitgehend schematisch, ein erstes bevorzugtes Ausführungsbeispiel einer erfindungsgemäßen Schaltungsanordnung,
- Fig. 2: wiederum weitgehend schematisch ein zweites bevorzugtes Ausführungsbeispiel einer erfindungsgemäßen Schaltungsanordnung und
- Fig. 3: grafische Darstellungen zur Erläuterung der erfindungsgemäßen Schaltungsanordnung.

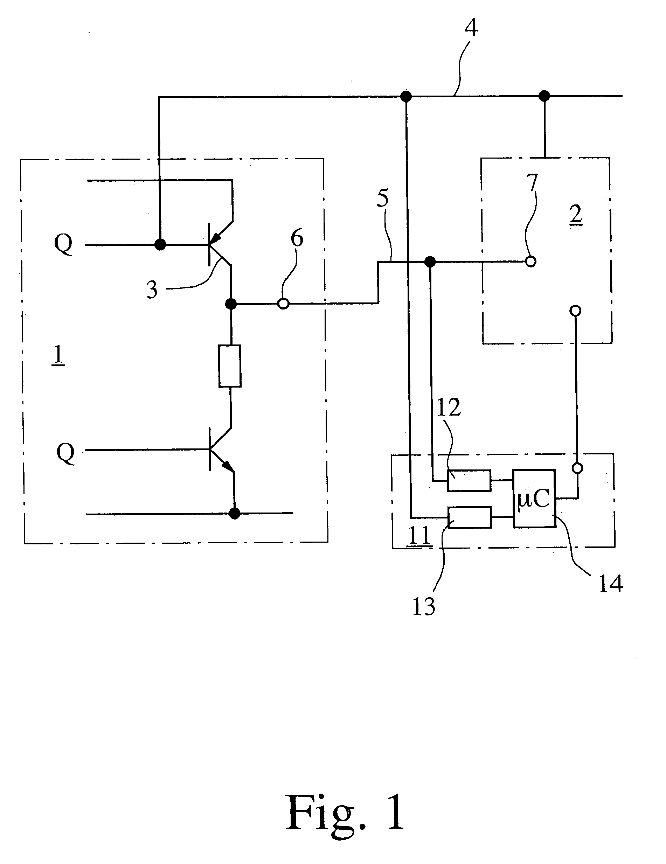

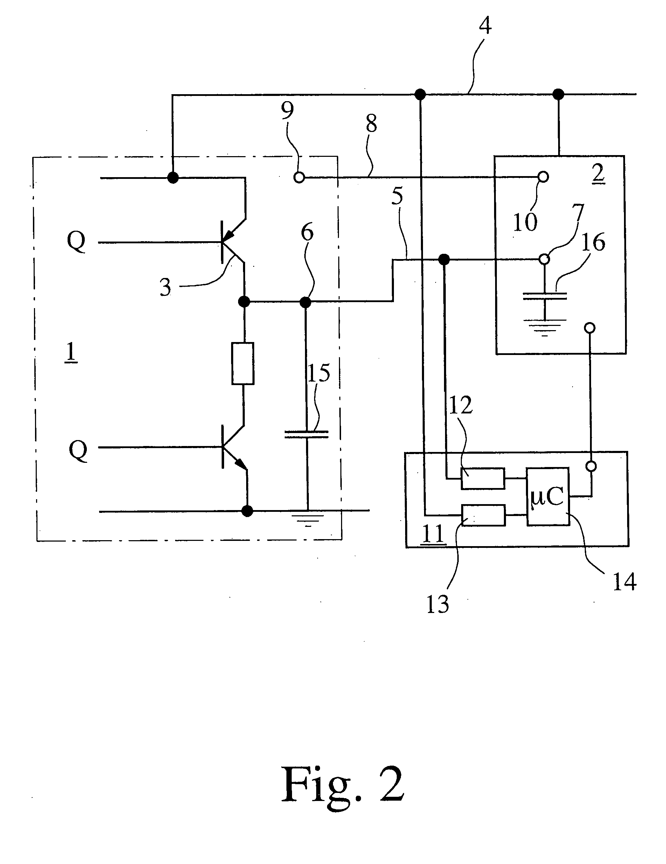

Die in den Fig. 1 und 2 dargestellten Schaltungsanordnungen weisen in ihrem grundsätzlichen Aufbau zunächst einen Sensor 1 und eine Auswerteeinheit 2 auf. Der Sensor I ist mit einer Sicherheitsendstufe 3 versehen. Die Funktionstüchtigkeit der Sicherheitsendstufe 3 ist im Ausführungsbeispiel nach Fig. 1 im Sensor 1, im Ausführungsbeispiel nach Fig. 2 durch die Auswerteeinheit 2 abfragbar.

Dargestellt ist, und zwar jeweils nur einpolig, eine Versorgungsspannungsleitung 4, über die der Sensor 1 und die Auswerteeinheit 2 ihre Versorgungsspannung erhalten, und eine Verbindungsleitung 5 zwischen dem Sensor 1 und der Auswerteeinheit 2. Konkret ist dazu der Ausgang 6 der Sicherheitsendstufe 3 mit einem entsprechenden Eingang 7 der Auswerteeinheit 2 verbunden.

Im Ausführungsbeispiel nach Fig. 1 ist die Funktionstüchtigkeit der Sicherheitsendstufe 3 des Sensors 1 im Sensor 1 selbst abfragbar. Innerhalb des Sensors 1 werden also Abfrageimpulse generiert, was im einzelnen nicht dargestellt ist.

Die Fig. 2 zeigt ein Ausführungsbeispiel, bei dem die Funktionstüchtigkeit der Sicherheitsendstufe 3 durch die Auswerteeinheit 2 abfragbar ist. Bei diesem Ausführungsbeispiel gibt es eine weitere Verbindungsleitung 8 zwischen einem Eingang 9 des Sensors 1 und einem Ausgang 10 der Auswerteeinheit. Über die Verbindungsleitung 8 erhält der Sensor 1 von der Auswerteeinheit 2 Abfrageimpulse.

Bei beiden Ausführungsbeispielen können die Abfrageimpulse wie die eigentlichen Schaltimpulse an den Steuereingang Q der Sicherheitsendstufe 3 gegeben werden und werden Antwortimpulse generiert, wenn die erfindungsgemäße Schaltungsanordnung insgesamt, insbesondere auch die Sicherheitsendstufe 3, funktionstüchtig ist. Diese Antwortimpulse gelangen dann vom Sensor 1 über die Verbindungsleitung 5 zur Auswerteeinheit 2.

Erfindungsgemäß ist nun eine die Spannung am Ausgang 6 der Sicherheitsendstufe 3, also die Ausgangsspannung der Sicherheitsendstufe 3 überwachende Überwachungseinheit 11 vorgesehen, die in Koinzidenz zum Abfragen der Sicherheitsendstufe 3 aktivierbar ist und die jeweils dann und nur dann einen die Funktionstüchtigkeit der Schaltungsanordnung darstellenden Antwortimpuls generiert, wenn die Ausgangsspannung der Sicherheitsendstufe 3 entweder einen vorgegebenen Wert, also eine Referenzspannung unterschreitet oder wenn Ausgangsspannung der Sicherheitsendstufe 3 die Versorgungsspannung des Sensors 1 um einen vorgegebenen Wert unterschreitet. Erfindungsgemäß wird also die Ausgangsspannung der Sicherheitsendstufe 3 überwacht und überprüft, und zwar immer genau dann, wenn ein Abfrageimpuls generiert wird, sei es nun wie im Ausführungsbeispiel nach Fig. 1, im Sensor 1, sei es, wie im Ausführungsbeispiel nach Fig. 2, in der Auswerteeinheit 2. Jeweils dann und nur dann wird ein die Funktionstüchtigkeit der Schaltungsanordnung insgesamt und damit vor allem auch die Funktionstüchtigkeit der Sicherheitsendstufe 3 darstellender Antwortimpuls generiert, wenn die Ausgangsspannung der Sicherheitsendstufe 3 entweder die Referenzspannung unterschreitet oder die Versorgungsspannung des Sensors 1 um einen vorgegebenen Wert unterschreitet.

In den Fig. 1 und 2 dargestellten Ausführungsbeispielen erfindungsgemäßer Schaltungsanordnungen weist die Überwachungseinheit 11 einen die Ausgangsspannung der Sicherheitsendstufe erfassenden A/D-Wandler 12, einen die Versorgungsspannung des Sensors 1 erfassenden A/D-Wandler 13 und einen die digitalisierte Ausgangsspannung der Sicherheitsendstufe 3 und die digitalisierte Versorgungsspannung des Sensors 1 vergleichenden Komparator 14 auf. Der Komparator 14 kann als µ-Controller ausgeführt sein.

Im übrigen zeigt die Fig. 2 insoweit ein bevorzugtes Ausführungsbeispiel der erfindungsgemäßen Schaltungsanordnung, als der Sensor 1 und die Auswerteeinheit 2 ausgangsseitig jeweils eine Linearisierungskapazität 15, 16 aufweisen. Dazu, warum die Linearisierungskapazitäten 15 und 16 vorgesehen sind und was damit erreicht werden kann, wird auf die insoweit weiter oben gemachten Ausführungen verwiesen.

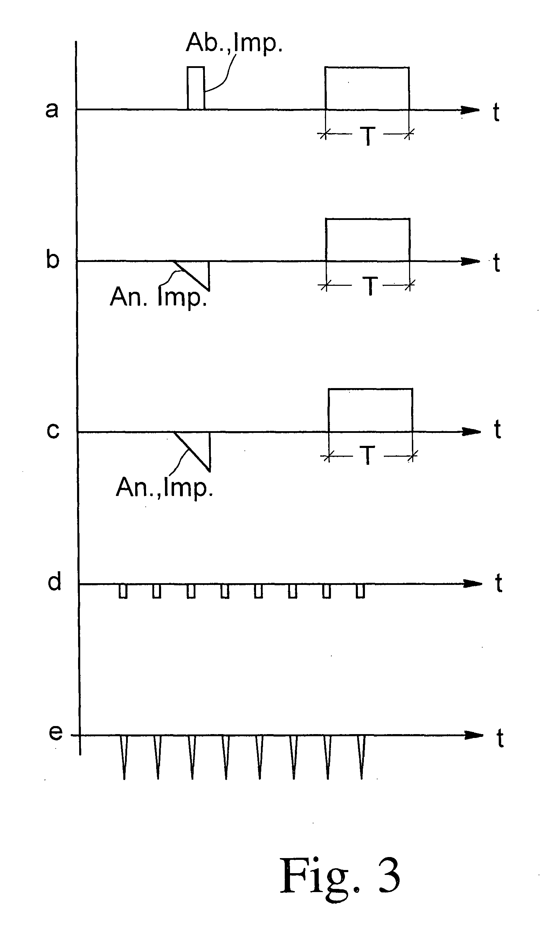

Fig. 3 zeigt - über der Zeit t - in der Skizze a einen Abfrageimpuls Ab., Imp. und die maximale Abfragezeit T, in der Skizze b für den Fall, daß die Ausgangsspannung der Sicherheitsendstufe 3 die Versorgungsspannung des Sensors I nicht um den vorgegebenen Wert unterschreitet, die Schaltungsanordnung also nicht funktionstüchtig ist, einen Antwortimpuls An., Imp., in der Skizze c einen Antwortimpuls An., Imp. für den Fall, daß die Ausgangsspannung der Sicherheitsendstufe 3 die Versorgungsspannung des Sensors 1 um den vorgegebenen Wert unterschreitet, die Schaltungsanordnung funktionstüchtig ist, sowie in den Skizzen d) und e) die Ausgangsspannungen der Sicherheitsendstufe 3, in der Skizze d) bei relativ hochohmiger Last, in der Skizze e) bei relativ niederohmiger Last.

## Patentansprüche

1. Schaltungsanordnung mit mindestens einem Sensor und mit einer Auswerteeinheit, wobei der Sensor eine Sicherheitsendstufe aufweist und die Funktionstüchtigkeit der Sicherheitsendstufe im Sensor und/oder durch die Auswerteeinheit abfragbar ist, **dadurch gekennzeichnet, daß** eine die Spannung am Ausgang (6) der Sicherheitsendstufe (3), also die Ausgangsspannung der Sicherheitsendstufe (3) überwachende Überwachungseinheit (11) vorgesehen ist, daß die Überwachungseinheit (11) in Koinzidenz zum Abfragen der Sicherheitsendstufe (3) aktivierbar ist und daß die Überwachungseinheit (11) jeweils dann und nur dann einen die Funktionstüchtigkeit der Schaltungsanordnung darstellenden Antwortimpuls generiert, wenn die Ausgangsspannung der Sicherheitsendstufe (3) einen vorgegebenen Wert, eine Referenzspannung unterschreitet oder wenn die Ausgangsspannung der Sicherheitsendstufe (3) die Versorgungsspannung des Sensors (1) um einen vorgegebenen Wert unterschreitet.

2. Schaltungsanordnung nach Anspruch 1, **dadurch gekennzeichnet, daß** durch die Überwachungseinheit (11) der Spannungswert der Ausgangsspannung der Sicherheitsendstufe (3) vor dem Auftreten jedes Abfrageimpulses erfaßt und gespeichert wird, daß der Spannungswert der Ausgangsspannung der Sicherheitsendstufe (3) nach dem Auftreten jedes Abfrageimpulses erfaßt wird und mit dem gespeicherten Spannungswert der Ausgangsspannung der Sicherheitsendstufe (3) vor dem Auftreten jedes Abfrageimpulses verglichen wird und daß dann, wenn die Differenz dieser beiden Spannungswerte einen vorgegebenen Wert überschreitet, Antwortimpulse generiert werden.

3. Schaltungsanordnung nach Anspruch 1 oder 2, **dadurch gekennzeichnet, daß** die Überwachungseinheit (11) einen die Ausgangsspannung der Sicherheitsendstufe (2) erfassenden A/D-Wandler (12), einen die Versorgungsspannung des Sensors (1) erfassenden A/D-Wandler (13) und einen die digitalisierte Ausgangsspannung der Sicherheitsendstufe (3) und die digitalisierte Versorgungsspannung des Sensors (1) vergleichenden Komparator (14) aufweist.

4. Schaltungsanordnung nach Anspruch 3, **dadurch gekennzeichnet, daß** der Komparator als Differenzverstärker ausgeführt ist.

5. Schaltungsanordnung nach Anspruch 3, **dadurch gekennzeichnet, daß** der Komparator (14) als µ-Controller ausgeführt ist.

6. Schaltungsanordnung nach einem der Ansprüche 1 bis 5, **dadurch gekennzeichnet, daß** der Sensor (1) oder/und die Auswerteeinheit (2) ausgangsseitig eine Linearisierungskapazität (15) oder (16) aufweist bzw. Linearisierungskapazitäten (15 und 16) aufweisen.

7. Verfahren zum Überwachen und Überprüfen der Funktionstüchtigkeit einer Schaltungsanordnung mit mindestens einem Sensor und mit einer Auswerteeinheit, wobei der Sensor eine Sicherheitsendstufe aufweist und die Funktionstüchtigkeit der Sicherheitsendstufe im Sensor und/oder durch die Auswerteeinheit abfragbar ist, **dadurch gekennzeichnet, daß** die Ausgangsspannung der Sicherheitsendstufe überwacht und überprüft wird, und zwar immer genau dann, wenn ein Abfrageimpuls generiert wird, und daß jeweils dann und nur dann ein die Funktionstüchtigkeit der Schaltungsanordnung darstellender Antwortimpuls generiert wird, wenn die Ausgangsspannung der Sicherheitsendstufe einen vorgegebenen Wert, eine Referenzspannung, unterschreitet oder wenn die Ausgangsspannung der Sicherheitsendstufe die Versorgungsspannung des Sensors um einen vorgegebenen Wert unterschreitet.
